# EUROPÄISCHE PATENTSCHRIFT

(11) **EP 3 103 195 B1**
(45) Veröffentlichungstag und Bekanntmachung des Hinweises auf die Patenterteilung: **05.08.2020**
(21) Anmeldenummer: 15702761.6
(22) Anmeldetag: 04.02.2015
(51) Int. Cl.: H03K 17/30, H03K 17/795

(54) **WEITBEREICHS-EINGANGSSCHALTUNG**
LARGE-RANGE INPUT CIRCUIT
CIRCUIT D'ENTRÉE À LARGE GAMME

(30) Priorität: 04.02.2014 DE 102014101353
(43) Veröffentlichungstag der Anmeldung: 14.12.2016
(73) Patentinhaber: Phoenix Contact GmbH & Co. KG, 32825 Blomberg (DE)
(72) Erfinder: JEEP, Benjamin, 32657 Lemgo (DE); THUER, Winfried, 32839 Steinheim (DE)
(74) Vertreter: Blumbach · Zinngrebe Patentanwälte PartG mbB
(86) Internationale Anmeldenummer: PCT/EP2015/052313
(87) Internationale Veröffentlichungsnummer: WO 2015/118017

(56) Entgegenhaltungen:
- EP-A1- 2 509 178
- US-A- 4 275 307
- US-A- 4 682 061

## Beschreibung

Die Erfindung bezieht sich auf eine Weitbereichs-Eingangsschaltung zur Aufbereitung und Weiterleitung von digitalen Signalen, die an Eingangsanschlüssen mit Werten sowohl im Bereich von Kleinspannungssignalen ≤ 120 V als auch im Bereich von Niederspannungssignalen < 1500 V anliegen können.

In industriellen Anlagen sind digitale Steuersysteme häufig mit Sensoren über ein Interfacesystem verbunden. Art und Spannungshöhe der Sensorsignale nehmen einen weiten Bereich ein. Das Interfacesystem zwischen den Sensoren und dem digitalen Steuersystem des jeweiligen Gerätes muss deshalb in der Lage sein, das jeweilige Eingangssignal an den digitalen Eingang des Steuersystems des jeweiligen Gerätes anzupassen.

Aus DE 10 2010 030 656 A1 ist eine Schaltungsanordnung für einen digitalen Eingang eines elektronischen Geräts bekannt, bei der eine Zenerdiode als Sperrglied zur Sperrung des Stromflusses unterhalb einer Schaltschwelle einer Eingangsspannung vorgesehen ist. Nachteilig ist, dass nur eine Schaltschwelle realisiert werden kann.

Aus US 4,275,307 ist eine Eingangsschaltung für ein digitales System bekannt, umfassend: eine Gleichrichterschaltung mit zwei Wechselstromeingangsanschlüssen und mit zwei Ausgangsanschlüssen, die eine an die Ausgangsanschlüsse der Gleichrichterschaltung angeschlossene Serienschaltung mit folgenden Elementen aufweist: eine Strombegrenzerschaltung zur Begrenzung des Stromes in der Serienschaltung auf einen vorgewählten maximalen Wert; eine Mehrzahl von in Serie geschalteten Zenerdioden mit Klemmen zum selektiven Kurzschließen der Zenerdioden, um den Spannungsabfall an der Serienschaltung zu verändern; und ein Licht emittierendes Element als Teil eines Fotokopplers zur Erzeugung eines elektrischen Signals in einem Lichtempfangsteil des Fotokopplers, wenn in der Serienschaltung Strom fließt; wobei eine Ausgangstreiberschaltung mit dem Lichtempfangselement verbunden ist, um das erzeugte Signal zu einem Signal mit logischem Pegel am Ausgangsanschluss zu verwandeln, das zur Anlage an einen Datenbus des digitalen Systems geeignet ist. Im einzelnen werden drei Zenerdioden mit Werten von 3 Volt, 7 Volt und 20 Volt Zenerspannung verwendet, die durch Nebenschlussleitungen überbrückbar sind, so dass Spannungsabfälle von 0, 3, 7, 10, 20, 23, 27 und 30 Volt einstellbar sind. Auf diese Weise kann das Ausgangssignal auf einen logischen Pegel geeignet zur Anlage an den Datenbus eines digitalen Steuersystems gebracht werden. Mit der bekannten Eingangsschaltung kann nur eine feste Einstellung der Schaltschwelle im Bereich der Kleinspannungssignale vorgenommen werden.

Der Erfindung liegt die Aufgabe zugrunde, eine Weitbereichs-Eingangsschaltung für digitale Signale zu schaffen, die dem Kleinspannungssignalbereich ≤ 120 V und/oder dem Niederspannungsbereich < 1500 V angehören können und die an eine Nutzerschaltung nach Aufbereitung weitergeleitet werden sollen. Es sollen Schaltschwellen im Bereich von Kleinspannungssignalen kleiner 120 V, als auch im Bereich von Niederspannungssignalen kleiner 1500 V flexibel, d. h. softwaremäßig, einstellbar sein. Insbesondere sollen Normschaltschwellen rasch einstellbar sein.

Die erfindungsgemäße Weitbereichs-Eingangsschaltung weist eine Reihenschaltung mit folgenden Elementen auf: einen eingangsseitigen Gleichrichter oder eine Gleichrichterschaltung, um wechselstrommäßig ankommende digitale Signale in Gleichstrom überzuführen und um einen Gleichstrom durch die Reihenschaltung zwischen zwei Eingangsanschlüssen zu ermöglichen; einen Stromregler zur Einstellung des Gleichstroms; zwei oder eine Mehrzahl n von in Reihe geschalteten, in Sperrrichtung gepolten Zenerdioden; und einen Optokoppler zur Bestimmung des Zustandes des digitalen Ausgangsanschlusses der Weitbereichs-Eingangsschaltung, wobei zusätzlich eine oder mehrere Überbrückungseinrichtungen der Zenerdioden vorgesehen sind, die über eine Mikroprozessorsteuerung wirksam oder unwirksam gemacht werden können, um die in Reihe geschalteten Zenerdioden einzeln oder in Gruppen in die Schaltung einzufügen oder durch Überbrückung unwirksam werden zu lassen.

Bei dieser Weitbereichs-Eingangsschaltung können mit wenig Aufwand mehrere Schaltschwellen auch für unterschiedliche Spannungsbereiche realisiert werden. Die Weitbereichs-Eingangsschaltung kann im Kleinspannungsbereich mit Normschaltschwellen, oder auch im Niederspannungsbereich mit den dort gültigen Normschaltschwellen betrieben werden.

Die Parametrierung der Schaltschwelle wird je nach unterschiedlichem Anwendungsbereich vorgenommen.

Ausführungsbeispiele der Erfindung werden anhand der Zeichnung beschrieben. Dabei zeigt:
Fig. 1 eine erste Ausführungsform einer Weitbereichs-Eingangsschaltung,
Fig. 2 eine zweite Ausführungsform einer Weitbereichs-Eingangsschaltung.

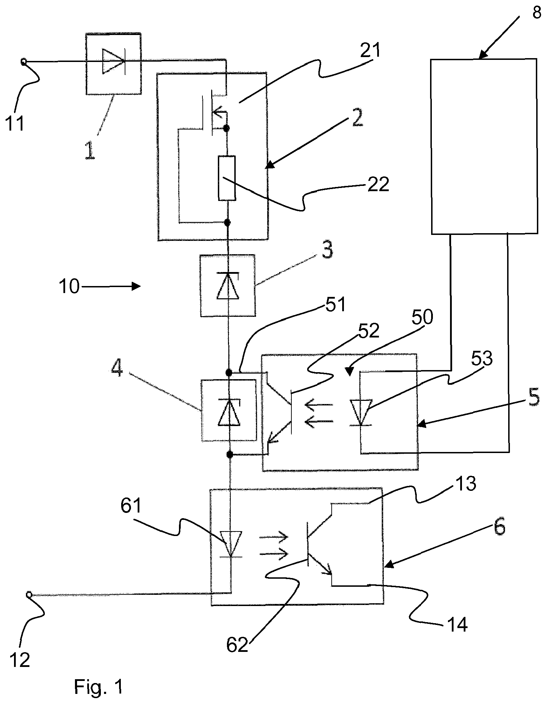

Fig. 1 zeigt eine Prinzipskizze der Weitbereichs-Eingangsschaltung. Der Signaleingang weist zwei Eingangsklemmen 11 und 12 auf, und der digitale Ausgangsanschluss zwei Ausgangsanschlussleitungen 13, 14. Eine Reihenschaltung 10 erstreckt sich zwischen den Eingangsklemmen 11, 12 und umfasst folgende Elemente: einen Gleichrichter 1, der auch als Gleichrichterschaltung realisiert sein kann, einen Stromregler 2, der als eine Stromquelle wirksam ist und den Gleichstrom für die Reihenschaltung 10 liefert, eine erste in Sperrrichtung gepolte Zenerdiode 3 für eine Schaltschwelle innerhalb des Bereichs der Kleinspannungssignale von ≤ 120 V, eine zweite in Sperrrichtung gepolte Zenerdiode 4 für eine Schaltschwelle innerhalb des Bereichs der Niederspannungssignale von < 1500 V, eine Überbrückungsschaltung 5 für die Zenerdiode 4 und einen Auslese-Optokoppler 6, der über die Ausgangsanschlussleitungen 13, 14 mit einer nicht dargestellten Nutzerschaltung verbunden ist.

Die Überbrückungsschaltung 5 enthält eine Überbrückungsleitung 51 und einen Hilfs-Optokoppler 50, der einen Fototransistor 52 und eine Leuchtdiode 53 enthält und über einen Mikroprozessor 8 gesteuert wird, um die Überbrückungsleitung 51 und den darin angeordneten Fototransistor leitend oder nichtleitend zu steuern.

Der Auslese-Optokoppler 6 enthält eine Leuchtdiode 61 und einen Fototransistor 62, um den Leuchtzustand der Leuchtdiode 61 "leuchtend" oder "nicht-leuchtend" in ein digitales Ausgangssignal an den Ausgangsanschlussleitungen 13, 14 zu wandeln.

Der Stromregler 2 dient zur Einstellung des die Reihenschaltung 10 durchfließenden Stromes auf einen Wert, wie er zum Betrieb der Leuchtdiode 61 benötigt wird, und enthält im dargestellten Ausführungsbeispiel einen selbstleitenden n-Kanal-MOSFET 21 und einen 750 Ω Widerstand 22 zwischen Gate-Anschluss und Source-Anschluss, um den Strom auf etwa 0,75 mA einzustellen. Die maximal zulässige Drain-Source-Spannung beträgt hier 500 V, was die maximal zulässige Spannung an den Eingangsklemmen 11, 12 festlegt. Der Stromregler 2 kann aber auch für höhere Spannungen gebaut werden, wenn der Niederspannungssignalbereich < 1500 V voll ausgeschöpft werden soll.

Es sei angenommen, dass die Weitbereichs-Eingangsschaltung sowohl eine Nennspannung von 24 V (= Kleinspannung) als auch eine Nennspannung von 230 V (= Niederspannung) digital erfassen soll. Der Gleichrichter 1 sorgt dafür, dass sowohl Wechselspannungssignale als auch Gleichspannungssignale erfasst werden können. Bei einer Nennspannung von 24 VDC liegt der von der Norm gegebene Übergangsbereich zwischen einer logischen 0 und einer logischen 1 zwischen 5 V und 15 V und bei einer Nennspannung von 230 VAC zwischen 40 V und 164 V. Die Zenerdiode 3 ist für die Einstellung der Schaltschwelle für den Bereich der Kleinspannungssignale zuständig und wird für eine Zenerspannung von 5,6 V gewählt. Wenn Signale im Bereich der Kleinspannungssignale ≤ 120 V zu erwarten sind, wird die Überbrückungsschaltung 5 aktiviert, um die Zenerdiode 4 zu überbrücken, was mittels des Hilfs-Optokopplers 50 geschieht, der über den Mikroprozessor 8 angesteuert wird. Eingangssignale unterhalb von 5 V werden beispielsweise als digitales Signal "0" und Eingangssignale über 15 V werden als digitales Signal "1" erkannt.

Wenn Eingangssignale im Bereich der Niederspannungssignale < 1500 V erwartet werden, wird die Überbrückungsschaltung 5 deaktiviert, so dass bei ankommenden Spannungs-Stromimpulsen beide Zenerdioden 3 und 4 beaufschlagt werden. Wenn eine Nennspannung von 230 V des Eingangssignals zu erwarten ist, dann liegt der normativ vorgeschriebene Übergangsbereich zwischen einer logischen 0 und einer logischen 1 zwischen 40 V und 164 V. Für diesen Fall wird die Zenerspannung der Zenerdiode 4 zu 56 V gewählt.

Als Optokoppler kann zum Bespiel der SFH 6156 von Siemens eingesetzt werden. Die Besonderheit besteht darin, dass der Anwender diesen Optokoppler zum Beispiel über den Mikroprozessor 8 ansteuern kann und dabei die Nennspannung von 230 VAC bewältigt werden kann ohne den Anwender zu gefährden. Trotz der hohen, berührungsgefährlichen Spannung von 230 VAC wird die elektrische Sicherheit gewährleistet.

Die Eingangsspannung kann innerhalb des Bereichs der Kleinspannungssignale < 120 V auch eine andere Nennspannung als 24 V aufweisen, beispielsweise 48 VDC. Hier gibt es einen Übergangsbereich von 10 bis 34 V, innerhalb welchem die Schaltschwelle einen beliebigen Spannungswert haben kann. Die Zenerspannung der Zenerdiode 3 wird in diesen Übergangsbereich hineingelegt.

Die dargestellte Schaltung kann um mehr als zwei Zenerdioden erweitert werden, wenn mehr als zwei Schaltschwellen benutzbar sein sollen. Dann wird eine Mehrzahl n von in Reihe geschalteten, in Sperrrichtung gepolten Zenerdioden 3, 4 und eine Mehrzahl n oder n-1 Überbrückungsschaltungen 5 in die Reihenschaltung 10 einbezogen.

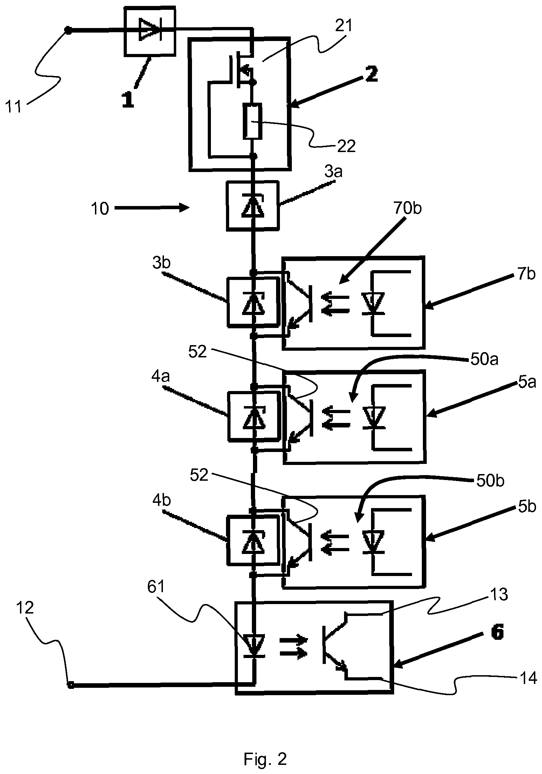

Fig. 2 zeigt eine Reihenschaltung der Weitbereichs-Eingangschaltung mit zwei in Sperrrichtung gepolten Zenerdioden 3a, 3b für zwei Schaltschwellen im Bereich der Kleinspannungssignale ≤ 120 V und mit zwei in Sperrrichtung gepolten Zenerdioden 4a, 4b für zwei Schaltschwellen im Bereich der Niederspannungssignale < 1500 V bei sonst mit Fig. 1 übereinstimmenden Schaltungsmerkmalen. Die Zenerdiode 3b ist mit einer Überbrückungsschaltung 7b überbrückbar, die mittels eines Hilfs-Optokopplers 70b wirksam gemacht werden kann. Dadurch kann eine weitere Schaltschwelle, zusätzlich zu der Schaltschwelle der Zenerdiode 3a, ausgewählt werden. Wie im Falle der Fig. 1 werden die Optokoppler über eine Mikroprozessorsteuerung "leitend" oder "nicht-leitend" angesteuert, die aus Gründen der Übersicht in Fig. 2 nicht eingezeichnet worden ist.

Es ist auch möglich, die Zenerdiode 3a mit einer Überbrückungsschaltung ("7a", nicht dargestellt) kurzzuschließen, um wechselweise die Zenerdiode 3a oder die Zenerdiode 3b wirksam werden zu lassen, um eine dritte Schaltschwelle für den Bereich der Kleinspannungssignale zur Verfügung zu stellen.

Ähnliche Überlegungen gibt es auch für den Bereich der Niederspannungssignale. Auch dort kann mit den in Reihe liegenden Zenerdioden 4a, 4b dafür gesorgt werden, dass unterschiedlich hohe Schaltschwellen realisierbar sind. Da die zu den jeweiligen Überbrückungsschaltungen 7b, 5a, 5b gehörigen Hilfs-Optokoppler 70b, 50a, 50b über einem dem Mikroprozessor 8 entsprechenden Mikroprozessor (nicht gezeichnet) ansteuerbar sind, lassen sich unterschiedliche Schaltschwellen rasch und problemlos einstellen.

Es versteht sich, dass die Anzahl der in Sperrrichtung gepolten und überbrückbaren Zenerdioden so gewählt werden kann, dass eine gewünschte Anzahl von Schaltschwellen realisiert wird.

Die Erfindung betrifft somit eine Weitbereichs-Eingangsschaltung für digitale Signale im Bereich der Kleinspannungssignale ≤ 120 V und im Bereich der Niederspannungssignale < 1500 V mit in Reihe geschalteten, in Sperrrichtung gepolten Zenerdioden, die jeweils mindestens eine Schaltschwelle im Bereich der Kleinspannungssignale bzw. im Bereich der Niederspannungssignale definieren und die durch Nichtüberbrückung als wirksam auswählbar sind, wobei die Überbrückung der jeweils nicht zur Wirkung kommenden Zenerdiode durch einen jeweiligen Hilfs-Optokoppler bewerkstelligt wird, der durch einen Mikroprozessor ansteuerbar ist.

## Patentansprüche

1. Weitbereichs-Eingangsschaltung zur Aufbereitung und Weiterleitung von digitalen Signalen, die an Eingangsanschlüssen mit Werten sowohl im Bereich von Kleinspannungssignalen ≤ 120 V als auch im Bereich von Niederspannungssignalen < 1500 V anliegen können, umfassend:
eine Mikroprozesssteurung (8) zur Abgabe von Steuersignalen in Abhängigkeit davon, ob Eingangssignale im Bereich der Kleinspannungssignale oder im Bereich der Niederspannungssignale zu erwarten sind, und
eine Reihenschaltung mit folgenden Elementen:
- einen eingangsseitigen Gleichrichter (1) oder eine eingangsseitige Gleichrichterschaltung, um wechselstrommäßig ankommende digitale Signale in Gleichstromform überzuführen;
- einen Stromregler (2), der zur Bewältigung sowohl von Kleinspannungssignalen ≤ 120 V als auch von Niederspannungssignalen < 1500 V ausgelegt ist, um den durch die Reihenschaltung fließenden Strom je auf einen vorgegebenen Wert einzustellen;
- eine erste, in Reihe geschaltete, in Sperrrichtung gepolte Zenerdiode (3), die für eine Schaltschwelle von ≤ 120 V innerhalb des Bereichs der Kleinspannungssignale ausgelegt ist,
- eine zweite, in Reihe geschaltete, in Sperrrichtung gepolte Zenerdiode (4), die, zusammen mit der ersten Zenerdiode (3), für eine Schaltschwelle von < 1500 V innerhalb des Bereichs der Niederspannungssignale ausgelegt ist,
- eine Überbrückungsschaltung (5) zur Überbrückung der zweiten Zenerdiode (4) enthaltend einen Hilfs-Optokoppler (50), und
- einen Auslese-Optokoppler (6), um die aufbereiteten digitalen Signale über Ausgangsanschlussleitungen (13, 14) an eine Nutzerschaltung weiterzuleiten,
- wobei die Mikroprozessorsteuerung (8) zur Steuerung des Hilfs-Optokopplers (50) in Abhängigkeit davon, ob Eingangssignale im Bereich der Kleinspannungssignale oder im Bereich der Niederspannungssignale anliegen, die zweite Zenerdiode (4) im Sinne der Überbrückung oder der NichtÜberbrückung steuert,
- wobei ferner, wenn ein digitales Kleinspannungssignal anliegt, die zweite Zenerdiode (4) überbrückt wird und die erste Zenerdiode (3) durch ihren Zustand "leitend" oder "sperrend" bestimmt, ob ein digitales Signal "1" oder "0" abgegeben wird, und
- wenn ein digitales Niederspannungssignal anliegt, wenigstens die zweite Zenerdiode (4) nicht überbrückt wird oder die erste und zweite Zenerdiode (3, 4) in Reihe geschaltet verbleiben, und die nicht überbrückte zweite Zenerdiode (4) oder die Zenerdioden-Reihenschaltung aus erster und zweiter Zenerdiode (3, 4) durch ihren Zustand "leitend" oder "sperrend" bestimmt bzw. bestimmen, ob ein digitales Signal "1" oder "0" abgegeben wird.

2. Weitbereichs-Eingangsschaltung nach Anspruch 1,
wobei eine Mehrzahl n von in Reihe geschalteten, in Sperrrichtung gepolten Zenerdioden (3a, 3b, 4a, 4b) und eine Mehrzahl n oder n-1 von Überbrückungsschaltungen (7b, 5a, 5b) mit Hilfs-Optokopplern (70b; 50a, 50b) zu den Zenerdioden vorgesehen sind, die über die Mikroprocessorsteuerung ansteuerbar sind, um innerhalb des Bereichs der Kleinspannungssignale und/oder des Bereichs der Niederspannungssignale jeweils weitere Schaltschwellen realisieren zu können.

3. Weitbereichs-Eingangsschaltung nach Anspruch 2,
wobei n=4 ist und für den Bereich der Kleinspannungssignale zwei in Sperrichtung gepolte Zenerdioden (3a, 3b) sowie für den Bereich der Niederspannungssignale zusätzlich zwei weitere in Sperrichtung gepolte Zenerdioden (4a, 4b) vorgesehen sind.

4. Weitbereichs-Eingangsschaltung nach Anspruch 3,
wobei eine der Zenerdioden (3b), die für den Bereich der Kleinspannungssignale zuständig ist, von einer Überbrückungsschaltung (7b) überbrückt wird, und
wobei beide Zenerdioden (4a, 4b), die für den Bereich der Niederspannungssignale zuständig sind, von je einer Überbrückungsschaltung (5a, 5b) überbrückt werden.

5. Weitbereichs-Eingangsschaltung nach einem der Ansprüche 1 bis 4,
wobei bei einer Nennspannung von 24 V innerhalb des Bereichs der Kleinspannungssignale ein Übergangsbereich zwischen einer logischen "0" und einer logischen "1" bei einer Schaltschwelle der ersten Zenerdiode (3) zwischen 5 und 15 V liegt.

6. Weitbereichs-Eingangsschaltung nach Anspruch 5,
wobei die erste Zenerdiode (3) eine Schaltschwelle bei 5,6 V aufweist.

7. Weitbereichs-Eingangsschaltung nach einem der Ansprüche 1 bis 6,
wobei bei einer Nennspannung von 230 V innerhalb des Bereichs der Niederspannungssignale ein Übergangsbereich zwischen einer logischen "0" und einer logischen "1" bei einer Schaltschwelle der Reihenschaltung der Zenerdioden zwischen 40 V und 164 V liegt.

8. Weitbereichs-Eingangsschaltung nach Anspruch 7,
wobei die zweite Zenerdiode (4) in der Reihenschaltung der Zenerdioden eine Schaltschwelle bei 56 V aufweist.

## Claims

1. A large-range input circuit for processing and forwarding digital signals which may be applied at input terminals with values both in the range of extra-low voltage signals of ≤ 120 V and in the range of low voltage signals of < 1500 V, said input circuit comprising
a microprocessor controller (8) for delivering control signals in dependence on whether input signals are to be expected in the range of extra-low voltage signals or in the range of low voltage signals, and
a series circuit including the following elements:
- an input-side rectifier (1) or an input-side rectifier circuit for converting incoming digital alternating current signals into direct current signals;
- a current regulator (2) designed for managing both extra-low voltage signals of ≤ 120 V and low voltage signals of < 1500 V for adjusting the current flowing through the series circuit to a predetermined value;
- a first series-connected reverse-biased Zener diode (3) which is designed for a switching threshold of ≤ 120 V within the range of extra-low voltage signals;
- a second series-connected reverse-biased Zener diode (4) which is designed along with the first Zener diode (3) for a switching threshold of < 1500 V within the range of low voltage signals;
- a bypass circuit (5) for bridging the second Zener diode (4), which includes an auxiliary optocoupler (50); and
- a readout optocoupler (6) for forwarding the processed digital signals to a user circuit via output connection lines (13, 14);
- wherein the microprocessor controller (8) controls the second Zener diode (4) in terms of being bridged or not bridged for controlling the auxiliary optocoupler (50) in dependence on whether input signals are applied in the range of extra-low voltage signals or in the range of low voltage signals;
- wherein furthermore, if a digital extra-low voltage signal is applied, the second Zener diode (4) is bridged and the first Zener diode (3) determines, by a "conductive" or "blocking" state thereof, whether a digital signal "1" or "0" is output; and
- if a digital low voltage signal is applied, at least the second Zener diode (4) is not bridged, or the first and second Zener diodes (3, 4) remain connected in series and the non-bridged second Zener diode (4) or the series-connected Zener diodes including the first and second Zener diodes (3, 4) determine, by a "conductive" or "blocking" state thereof, whether a digital signal "1" or "0" is output.

2. The large-range input circuit as claimed in claim 1, comprising a plurality n of series-connected reverse-biased Zener diodes (3a, 3b, 4a, 4b) and a plurality n or n-1 of bypass circuits (7b, 5a, 5b) with auxiliary optocouplers (70b; 50a, 50b) for said Zener diodes, which can be driven by said microprocessor controller to implement further switching thresholds within said range of extra-low voltage signals and/or said range of low voltage signals.

3. The large-range input circuit as claimed in claim 2, wherein n = 4, and wherein two reverse-biased Zener diodes (3a, 3b) are provided for the range of extra-low voltage signals and additionally two further reverse-biased Zener diodes (4a, 4b) are provided for the range of low voltage signals.

4. The large-range input circuit as claimed in claim 3, wherein one of the Zener diodes (3b) which is responsible for the range of extra-low voltage signals is bridged by a bypass circuit (7b); and
wherein each of the two Zener diodes (4a, 4b) which are responsible for the range of low voltage signals are bridged by a respective bypass circuit (5a, 5b).

5. The large-range input circuit as claimed in any of claims 1 to 4, wherein at a nominal voltage of 24 V within the range of extra-low voltage signals, a transition region between a logical "0" and a logical "1" is at a switching threshold of the first Zener diode (3) between 5 and 15 V.

6. The large-range input circuit as claimed in claim 5, wherein the first Zener diode (3) has a switching threshold at 5.6 V.

7. The large-range input circuit as claimed in any of claims 1 to 6, wherein at a nominal voltage of 230 V within the range of low voltage signals, a transition region between a logical "0" and a logical "1" is at a switching threshold of the series-connected Zener diodes between 40 V and 164 V.

8. The large-range input circuit as claimed in claim 7, wherein the second Zener diode (4) of the series-connected Zener diodes has a switching threshold at 56 V.

## Revendications

1. Circuit d'entrée à large gamme pour le traitement et la transmission de signaux numériques qui peuvent être présents au niveau de connexions d'entrée avec des valeurs aussi bien dans la gamme de signaux de très petite tension ≤ 120 V que dans la gamme de signaux de basse tension < 1 500 V, comprenant :
une commande par microprocesseur (8) pour l'émission de signaux de commande selon que des signaux d'entrée doivent être attendus dans la plage des signaux de très petite tension ou dans la plage des signaux de basse tension, et
un montage en série ayant les éléments suivants :
- un redresseur (1) côté entrée ou un circuit redresseur côté entrée pour, au niveau courant alternatif, transformer en forme de courant continu des signaux numériques entrants ;
- un régulateur de courant (2) qui est conçu pour maîtriser aussi bien des signaux de très petite tension ≤ 120 V que des signaux de basse tension < 1 500 V pour régler respectivement à une valeur prescrite le courant traversant le montage en série ;
- une première diode Zener (3) montée en série, polarisée dans le sens bloquant, qui est conçue pour un seuil de commutation de ≤ 120 V à l'intérieur de la gamme des signaux de très petite tension,
- une deuxième diode Zener (4) montée en série, polarisée dans le sens bloquant, qui, conjointement avec la première diode Zener (3), est conçue pour un seuil de commutation de < 1 500 V à l'intérieur de la gamme des signaux de basse tension,
- un circuit de pontage (5) pour le pontage de la deuxième diode Zener (4) contenant un optocoupleur auxiliaire (50), et
- un optocoupleur de lecture (6) pour transmettre à un circuit d'utilisateur, via des lignes de connexion de sortie (13, 14), les signaux numériques traités,
- où la commande par microprocesseur (8) pour la commande de l'optocoupleur auxiliaire (50) commande la deuxième diode Zener (4) dans le sens du pontage ou du non-pontage selon que les signaux d'entrée sont présents dans la gamme des signaux de très petite tension ou dans la gamme des signaux de basse tension,
- où en outre, en présence d'un signal de très petite tension numérique, la deuxième diode Zener (4) est pontée, et la première diode Zener (3) détermine, par son état « passant » ou « bloquant », si un signal numérique « 1 » ou « 0 » est émis, et
- en présence d'un signal de basse tension numérique, au moins la deuxième diode Zener (4) n'est pas pontée ou la première et la deuxième diode Zener (3, 4) demeurent montées en série, et la deuxième diode Zener (4) non pontée ou le montage en série des diodes Zener composé de la première et de la deuxième diode Zener (3, 4) détermine ou respectivement déterminent par leur état « passant » ou « bloquant » si un signal numérique « 1 » ou « 0 » est émis.

2. Circuit d'entrée à large gamme selon la revendication 1,
où il est prévu une pluralité n de diodes Zener (3a, 3b, 4a, 4b) montées en série, polarisées dans le sens bloquant, et une pluralité n ou n-1 de circuits de pontage (7b, 5a, 5b) avec des optocoupleurs auxiliaires (70b ; 50a, 50b) pour les diodes Zener, qui peuvent être attaqués par le biais de la commande par microprocesseur pour pouvoir réaliser respectivement d'autres seuils de commutation à l'intérieur de la gamme des signaux de très basse tension et/ou de la gamme des signaux de basse tension.

3. Circuit d'entrée à large gamme selon la revendication 2,
où n=4 et, pour la gamme des signaux de très basse tension, il est prévu deux diodes Zener (3a, 3b) polarisées dans le sens bloquant de même que, pour la gamme des signaux de basse tension, il est prévu en plus deux autres diodes Zener (4a, 4b) polarisées dans le sens bloquant.

4. Circuit d'entrée à large gamme selon la revendication 3,
où une des diodes Zener (3b) qui est compétente pour la gamme des signaux de très basse tension, est pontée par un circuit de pontage (7b), et où les deux diodes Zener (4a, 4b) qui sont compétentes pour la gamme des signaux de basse tension sont pontées par respectivement un circuit de pontage (5a, 5b).

5. Circuit d'entrée à large gamme selon l'une des revendications 1 à 4,
où, pour une tension nominale de 24 V, à l'intérieur de la gamme des signaux de très basse tension, une gamme de transition est comprise entre un « 0 » logique et un « 1 » logique pour un seuil de commutation de la première diode Zener (3) entre 5 et 15 V.

6. Circuit d'entrée à large gamme selon la revendication 5,
où la première diode Zener (3) présente un seuil de commutation de 5,6 V.

7. Circuit d'entrée à large gamme selon l'une des revendications 1 à 6,
où, pour une tension nominale de 230 V, à l'intérieur de la gamme des signaux de basse tension, une gamme de transition est comprise entre un « 0 » logique et un « 1 » logique pour un seuil de commutation du circuit en série des diodes Zener (3) entre 40 V et 164 V.

8. Circuit d'entrée à large gamme selon la revendication 7,
où la deuxième diode Zener (4) dans le circuit en série des diodes Zener présente un seuil de commutation de 56 V.
